# DEMANDE DE BREVET EUROPEEN

(11) **EP 0 540 797 A1**
(43) Date de publication de la demande: **12.05.1993**
(21) Numéro de dépôt: 91460046.5
(22) Date de dépôt: 07.11.1991
(51) Int. Cl.: H01L 31/18, H01L 31/05

(54) **Machine à mettre en rangée et à souder aux conducteurs qui les relient entre eux une pluralité de dispositifs à semi-conducteurs**

(71) Demandeur: Leon, Paul, F-27630 Berthenonville (FR)
(72) Inventeur: Leon, Paul, F-27630 Berthenonville (FR)
(74) Mandataire: Le Guen, Louis François

(57) **Abrégé**

La présente invention concerne une machine à mettre en rangée et à souder aux conducteurs qui les relient entre eux une pluralité de dispositifs à semi-conducteurs, notamment de dispositifs photosensibles. Ceux-ci sont par exemple constitués de plaques qui comprennent, sur leurs faces avant et arrière, des collecteurs de prise de contact. Une machine selon l'invention comprend un premier poste où, sur une première file constituée d'une pluralité de chariots contigus, sont mis en place, selon une rangée, lesdits dispositifs et sont soudés, sur lesdits collecteurs, des conducteurs qui relient, entre eux, électriquement lesdits dispositifs, un second poste prévu pour recevoir une file de chariots issue du premier poste sur lesquels reposent lesdits dispositifs disposés en une rangée et soudés au premier poste et pour décharger ladite rangée de dispositifs, et un troisième poste où est mise en attente une file de chariots dont ladite rangée de dispositifs vient d'être déchargée au second poste. Les opérations de décharge d'une file au second poste et de sa mise en attente au troisième poste sont réalisées consécutivement pendant que, sur une autre file au premier poste, sont réalisés l'assemblage et le soudage desdits dispositifs.

## Description

La présente invention concerne une machine à mettre en rangée et à souder aux conducteurs qui les relient entre eux une pluralité de dispositifs à semi-conducteurs, notamment de dispositifs photosensibles.

De tels dispositifs photosensibles sont par exemple décrits dans les documents de brevet EP-A-427 934, US-A-4 492 812, US-A-4 393 576 et US-A-4 246 693. Ils sont essentiellement constitués d'une plaquette de silicium amorphe ou polycristallin sur laquelle on a réalisé une pluralité d'éléments à semi-conducteurs photosensibles, tels que des jonctions PN, des structures PIN, etc. Des collecteurs auxquels sont reliées les bornes des éléments photosensibles sont respectivement prévus sur les faces avant et arrière de ces plaquettes pour réaliser leurs connexions électriques vers l'extérieur. Différentes méthodes sont utilisées pour réaliser ces collecteurs et on se reportera, pour de plus amples informations sur le sujet, aux documents cités ci-dessus. Précisons seulement, ici, que ces collecteurs sont généralement recouverts d'une couche de soudure pouvant fondre à une température de l'ordre de 200 °C en vue des opérations subséquentes de soudage à des conducteurs de connexion.

Pour réaliser des capteurs solaires de relativement forte puissance, on est contraint de relier entre eux plusieurs de tels dispositifs photosensibles. Généralement, on réalise des panneaux comportant plusieurs rangées d'un certain nombre de dispositifs photosensibles tels que ceux qui viennent d'être décrits.

Le but de l'invention est ainsi de prévoir une machine qui permet de réaliser des rangées de tels dispositifs et, en particulier, de réaliser les opérations de mise en place des dispositifs individuels et de soudage des conducteurs reliant électriquement entre eux ces dispositifs, en vue d'obtenir de telles rangées.

Pour mener à bien la réalisation par une machine d'une rangée de dispositifs à semi-conducteurs, il y a lieu en général de prévoir au moins quatre opérations: la mise en place d'un certain nombre de dispositifs individuels selon une rangée, la pose sur ces dispositifs mis en rangée de conducteurs qui assurent leurs liaisons électriques, le soudage de ces conducteurs sur ces dispositifs, puis l'extraction de la rangée ainsi réalisée pour sa manipulation sur une autre machine où là elles sont assemblées en un panneau solaire.

On citera, à titre d'exemple de telles machines, les documents de brevet US-A-4 534 502 et WO-A-86 03623. De même, concernant des procédés de connexion de conducteurs sur des dispositifs photosensibles, on citera les documents de brevet DE-A-3 612 269, FR-A-2 549 296 et FR-A-2 514 565.

Un autre but de l'invention est de prévoir une machine dont la structure soit relativement plus simple et donc moins coûteuse que celles qui sont décrites dans les documents évoqués ci-dessus, mais dont les quatre opérations mentionnées ci-dessus soient, dans leur ensemble, réalisées plus rapidement, étant entendu qu'on ne cherche pas ici à proposer des machines qui permettraient d'augmenter la vitesse de chacune de ces opérations prises individuellement.

Pour ce faire et selon une première caractéristique de l'invention, une telle machine comprend un premier poste où, sur une file constituée d'une pluralité de chariots contigus, sont mis en place, selon une rangée, lesdits dispositifs et sont soudés, sur leurs collecteurs, des conducteurs qui relient, entre eux, électriquement lesdits dispositifs, un second poste prévu pour, d'une part, recevoir une file de chariots issue du premier poste sur lesquels reposent lesdits dispositifs disposés en une rangée et soudés au premier poste et pour, d'autre part, décharger ladite rangée de dispositifs, et un troisième poste où est mise en attente une file de chariots dont ladite rangée de dispositifs vient d'être déchargée au second poste, les opérations de décharge d'une file au second poste et de sa mise en attente au troisième poste étant réalisées consécutivement pendant que, sur une autre file au premier poste, sont réalisés l'assemblage et le soudage desdits dispositifs.

Par ces moyens, c'est-à-dire par l'utilisation de deux files de chariots identiques et par la présence de trois postes distincts, le temps nécessité pour décharger une rangée de dispositifs d'une file, ceci en vue de son extraction pour des opérations subséquentes, est masqué par le temps nécessaire à la mise en place des dispositifs photosensibles et au soudage des conducteurs sur ces dispositifs. On a ainsi par rapport à une machine où l'opération d'assemblage d'une rangée et celle de décharge d'une rangée sont consécutives, divisé sensiblement par deux le temps d'exécution d'une rangée. En effet, dans l'invention, ces deux opérations sont réalisées simultanément.

Selon une autre caractéristique de l'invention, le premier poste est constitué d'un premier emplacement où, pour chaque chariot d'une file, un dispositif à semi-conducteur est d'abord positionné sur ledit chariot, puis des conducteurs sont amenés et positionnés sur ledit dispositif de manière que lesdits conducteurs puissent se trouver en contact avec les électrodes dudit dispositif, lesdits conducteurs ayant une première extrémité reposant sur ledit dispositif et l'autre sur le chariot suivant dans la file, et enfin où des moyens de pressage pressent l'ensemble ainsi formé dudit dispositif, des conducteurs éventuels sur sa face arrière et des conducteurs sur sa face avant, et un second emplacement où des moyens de chauffage fournissent de la chaleur auxdits conducteurs pour effectuer leur soudage sur lesdits collecteurs de contact, chaque chariot d'une file étant prévu pour d'abord passer devant le premier emplacement puis devant le second emplacement.

On a ainsi prévu des moyens qui permettent de mettre en place les dispositifs en rangée et de souder les conducteurs qui les relient entre eux, le temps de soudage étant masqué par la mise en place des dispositifs sur les chariots. Ainsi, le temps nécessité pour la réalisation d'une rangée est égal au temps de mise en place d'un dispositif et des conducteurs correspondants multiplié par le nombre de dispositifs dans la rangée. Là aussi, on a sensiblement divisé le temps de réalisation par deux.

Notons que c'est parce qu'on a prévu d'assembler les dispositifs sur des chariots appartenant à une file que l'on peut réaliser simultanément l'opération de mise en place d'un dispositif et des conducteurs correspondants et l'opération de soudage des conducteurs sur le dispositif précédent.

Selon une caractéristique de l'invention, chaque chariot est muni de moyens de chauffage qui lui sont propres.

Selon une autre caractéristique de l'invention, lesdits moyens de chauffage sont constitués de moyens d'émission infrarouge, tels qu'au moins une résistance électrique.

Selon une autre caractéristique de l'invention, deux électrodes de mesure, une en cuivre et l'autre en cupronickel, sont prévues pour venir en contact, pendant l'opération de soudage, avec au moins un des conducteurs reliant chaque dispositif à semi-conducteur entre eux, ladite électrode en cupronickel sur les conducteurs formant alors un thermocouple, une tension représentative de la température de la soudure étant délivrée aux bornes des deux électrodes de mesure, ladite tension pouvant être fournie à une unité de commande qui pilote lesdits moyens de chauffage.

Par cette caractéristique, on a prévu des moyens qui permettent de contrôler la température ainsi que la montée en température de la zone qui est soudée, c'est-à-dire les conducteurs sur les dispositifs photosensibles.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels:
la Fig. 1 est une vue de dessus schématique d'une machine selon l'invention,
les Figs. 2a à 2c sont des vues de côté schématiques qui illustrent le fonctionnement de la machine selon l'invention, et
la Fig. 3 est une vue de côté schématique d'un chariot équipant une machine selon l'invention.

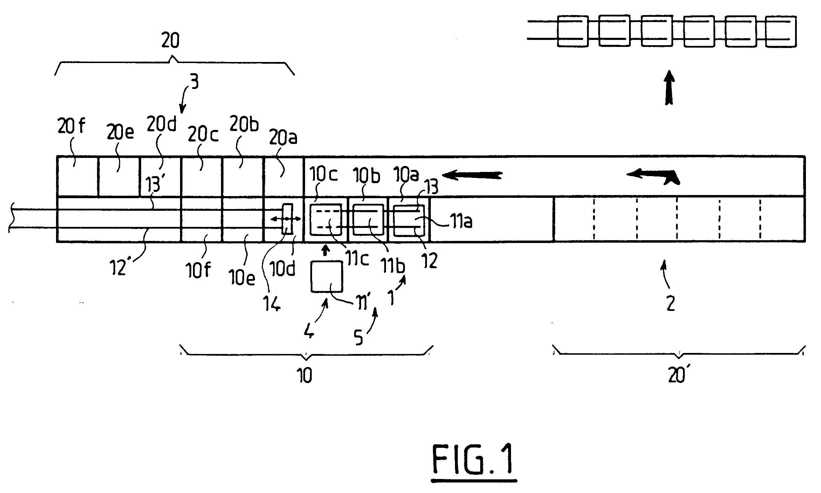

La machine représentée schématiquement à la Fig. 1 est constituée essentiellement de trois postes 1, 2 et 3 où sont effectuées les différentes phases de mise en rangée de dispositifs à semi-conducteurs. Ceux-ci sont, par exemple, des dispositifs photosensibles constitués de plaques de silicium dans lesquelles sont formées des jonctions PN. Les régions de ces jonctions sont respectivement reliées à des collecteurs de contact qui sont, par exemple, respectivement imprimés sur la face avant et la face arrière de chaque dispositif.

Au premier poste 1, est réalisé l'ensemble des opérations de mise en place des dispositifs individuels 11 et de soudure des conducteurs 12 et 13 reliant respectivement un dispositif 11 à son précédent et à son suivant. Ces opérations sont effectuées sur une première file 10 de chariots individuels 10a à 10f contigus et alignés. Un chariot étant prévu pour ne recevoir qu'un seul dispositif 11, le nombre de chariots pour une file 10 est égal au nombre de dispositifs dans une rangée de dispositifs. Sur la Fig. 1, ce nombre est de six.

Sur la Fig. 1, on voit encore un dispositif 11' qui est préparé pour être introduit dans la file 10 ainsi que des moyens 14 prévus pour venir positionner des conducteurs 12' et 13' sur le dispositif 11c.

Au second poste 2, on a représenté, en pointillés, une seconde file 20' de chariots identique à la première. Cette seconde file provient du poste 1 par une simple opération de translation. A ce poste, les dispositifs 11a à 11f qui ont été assemblés en une rangée au poste précédent 1, sont saisis, par exemple par des moyens à succion (non représentés), pour être emmenés vers un autre poste de la même machine ou vers une autre machine où ils sont assemblés en un capteur solaire à plusieurs rangées de dispositifs photosensibles individuels.

Une fois une rangée de dispositifs 11 retirée des chariots de la file 20' au poste 2 et pendant qu'au poste 1 une nouvelle rangée est mise en oeuvre, la seconde file 20 est emmenée à un troisième poste. Là, elle sera mise en attente, et lorsque la file 10 aura glissé vers le poste 2, elle prendra sa place au poste 1.

On a remarqué que la file 20' est représentée en pointillés car elle a déjà été déplacée vers le poste 3.

Ainsi, lorsqu'une rangée complète de dispositifs 11 a à 11f est assemblée et soudée au poste 1, la file correspondante glisse vers le poste 2. Pendant ce temps, la file en attente au poste 4 est mise en place au poste 1 et une nouvelle rangée peut commencer à être fabriquée. Pour ce faire, la file 10 est avancée d'un pas pour que le premier chariot 10a se trouve prêt à recevoir un dispositif individuel 11', puis, une fois l'opération de mise en place des conducteurs 12' et 13' terminée, elle est de nouveau avancée d'un pas, et ainsi de suite jusqu'à l'assemblage complet, comme il sera expliqué ci-dessous.

Par ces moyens, le temps occupé à décharger les chariots au poste 2 est masqué par le temps de mise en oeuvre d'une rangée de dispositifs 11 au poste 1. Les rangées sortent donc de la machine avec une période correspondant au temps nécessaire pour la mise en oeuvre de l'opération au poste 1. Par rapport aux machines dans lesquelles ces deux opérations distinctes sont réalisées l'une après l'autre, cette période est sensiblement divisée par deux.

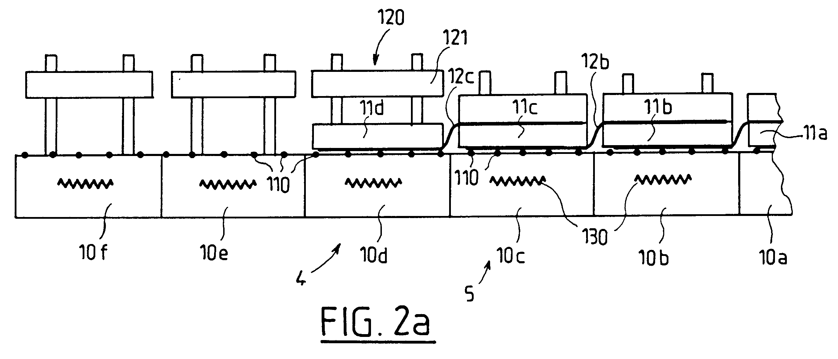

Aux Figs. 2a à 2c, on a représenté, schématiquement et vu de côté, le poste 1. On voit des chariots identiques 10a à 10f dans une file 10. Chaque chariot 10a à 10f de la file 10 est prévu pour avancer pas à pas dans la file 10. Le chariot 10d se trouve, sur la Fig. 2a, à l'emplacement référencé 4 où sont mis en place, d'une part, les dispositifs individuels 11 et, d'autre part, les conducteurs 12 et 13 qui les relient entre eux dans une rangée. A l'emplacement suivant référencé 5, espacé d'un pas du premier emplacement 4, est réalisée l'opération de soudage proprement dite. Chaque chariot de la file 10 passe d'abord par l'emplacement 4 puis par l'emplacement 5.

Chaque chariot est constitué d'un boîtier 100 qui est ouvert sur sa face supérieure au moyen d'une grille 110 schématisée ici par des tiges dans un plan normal à celui de la Fig. La grille 110 de chaque chariot est prévue pour recevoir un dispositif individuel 11. Au-dessus de la grille 110, sont prévus des moyens 120 qui sont par exemple constitués d'un presseur 121 pouvant coulisser verticalement et servant à presser le dispositif 11 sur la grille 110 afin d'assurer son positionnement stable. Le boîtier 100 de chaque chariot enferme un moyen de chauffage 130, tel qu'une ou plusieurs résistances électriques prévues pour rayonner dans l'infrarouge.

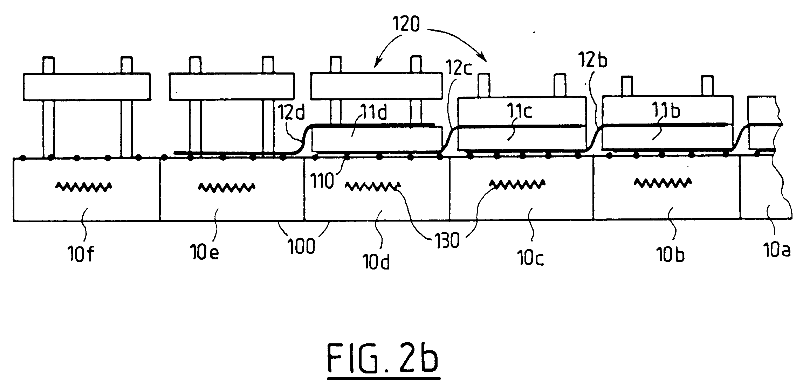

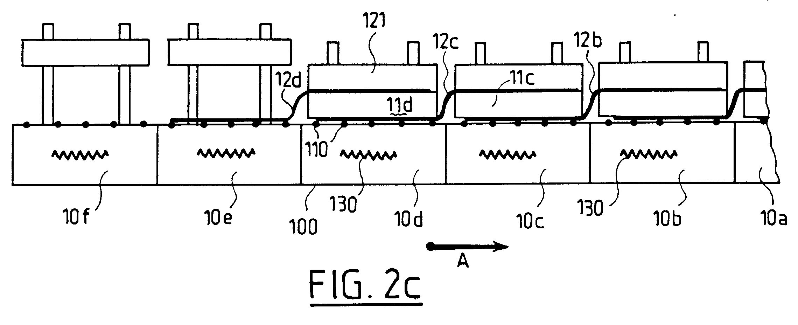

Par des moyens appropriés connus de l'homme de métier, comme par exemple une pince ou des pointes à effet de succion (non représentés), un dispositif 11d est posé sur la grille 110 du chariot 10d qui est positionné à l'emplacement 4, de manière que les collecteurs de contact qu'il comporte sur sa face inférieure puissent se trouver en contact avec les conducteurs 12c, 13c (seul 12c est visible sur les Figs. 2a à 2c) déjà mis en place sur le dispositif précédent 11c (Fig. 1 et 2a). Puis, par des moyens 14 (Fig. 1) également connus de l'homme du métier dans le domaine de la technique, on vient positionner, sur le dispositif 11d, deux conducteurs 12d et 13d (un seul est visible sur la Fig. 2b), leurs extrémités avant à proximité du bord avant du dispositif 11d et leurs extrémités arrière sur la grille 110 du chariot 10e suivant. Les conducteurs 12 et 13 sont mis en place de manière qu'ils se trouvent en contact ou puissent se trouver en contact avec les collecteurs conducteurs de contact prévus sur les faces inférieure et supérieure de chaque dispositif 11. Ces collecteurs et les conducteurs 12 et 13 ont, par ailleurs subis un traitement de dépôt d'une couche de soudure dont la composition et le procédé de dépôt, ne faisant pas l'objet de la présente invention, ne sont pas décrits ici plus en détail. Enfin, par les moyens de pressage 120, on presse, avec une force contrôlée, l'ensemble formé du dispositif 11d, des conducteurs 12c et 13c sur sa face inférieure et des conducteurs 12d et 13d sur sa face supérieure (Fig. 2c).

A ce moment, l'ensemble de la file 10 est avancée d'un pas, comme le montre la flèche A de la Fig. 2c, et un cycle peut recommencer sur le chariot 10e.

Pendant qu'à l'emplacement 4 sont mis en place un dispositif 11 et les conducteurs 12 et 13 correspondants, comme il vient d'être décrit, on alimente, à l'emplacement 5, la résistance 130 du chariot précédent (11c sur les Figs 2a à 2c). Le dispositif 11c est alors soumis à un flux de chaleur qui élève sa température jusqu'à environ 200 °C. Cette température est suffisante pour réaliser le soudage des conducteurs supérieurs 12c, 13c et des conducteurs inférieurs 12b, 13b (Figs. 2a à 2c) sur les lignes conductrices correspondantes sur le dispositif 11c. Par exemple, une durée de quelques secondes suffit à atteindre la température de soudage.

Notons qu'à cette étape, les moyens de pressage 120 sont en action et maintiennent les dispositifs 11 en place. Ils ne seront désactivés qu'au moment de déchargement au poste 2.

On notera que le dispositif 11a, étant le premier de la rangée de dispositifs 11 en fabrication, repose directement sur la grille 110 du chariot 10a.

On comprendra que les moyens mis en oeuvre par l'invention permettent de diminuer le temps de réalisation d'une rangée de dispositifs. En effet, le temps de soudage est masqué par le temps de mise en place d'un dispositif 11 et des conducteurs 12 et 13. Ainsi, le temps nécessaire à la mise en oeuvre d'une rangée de dispositifs correspond seulement à n fois le temps nécessaire à la mise en place d'un dispositif 11 et de ses conducteurs 12 et 13, n étant le nombre de dispositifs 11 dans une rangée (également le nombre de chariots).

Lorsque tous les chariots 10a à 10f d'une file 10 ont reçu un dispositif 11 et ses conducteurs 12 et 13 et que ceux-ci ont été soudés, la file est déplacée du poste 1 au poste 2, comme cela a déjà été expliqué.

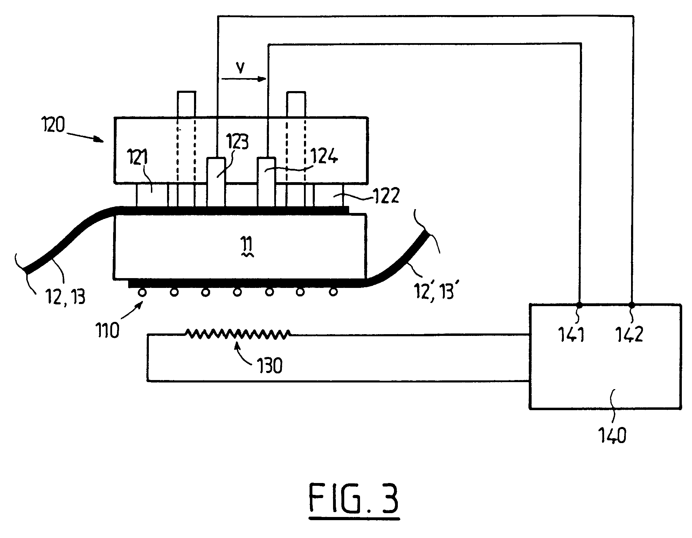

A la Fig. 3, on a représenté schématiquement un dispositif 11 monté sur une grille 110 d'un chariot et des moyens de pressage qui le maintiennent en place sur cette grille. Les moyens de pressage sont, sur cette Fig., constitués de deux doigts transversaux 121 et 122 venant se plaquer sur les conducteurs 12 et 13 de la face supérieure du dispositif 11. Ils sont encore munis de deux électrodes 123 et 124 qui prennent contact sur les conducteurs supérieurs 12 et 13.

On a représenté les moyens de chauffage par une résistance 130 reliée, pour être alimentée, à une unité de contrôle 140. Celle-ci a deux entrées 141 et 142 qui sont respectivement reliées aux électrodes 123 et 124.

Généralement, les conducteurs de liaison 12 et 13 sont en cuivre. Avantageusement, une électrode 123 est en cuivre alors que l'autre est en cupronickel 124. Ainsi, l'électrode en cuivre 123 établit un contact sur les conducteurs 12 et 13 en cuivre alors que l'électrode en cupronickel 124 constitue, avec les conducteurs en cuivre 12 et 13, des thermocouples qui engendrent une tension qui est directement fonction de la température du contact, c'est-à-dire, à quelques pertes près, directement proportionnelle à la température des conducteurs 12 et 13, en particulier au moment de l'opération de soudage. Cette tension est délivrée à l'unité de contrôle 140 qui pilote alors le courant traversant la résistance 130. Par ce moyen, il est possible de contrôler la température de même que la montée en température des conducteurs 12 et 13 et du dispositif au moment de leurs soudages.

## Revendications

1. Machine à mettre en rangée et à souder aux conducteurs qui les relient entre eux une pluralité de dispositifs à semi-conducteurs, notamment de dispositifs photosensibles, lesdits dispositifs étant constitués de plaques qui comprennent, sur leurs faces avant et arrière, des collecteurs de prise de contact, caractérisée en ce qu'elle comprend un premier poste où, sur une première file constituée d'une pluralité de chariots contigus, sont mis en place, selon une rangée, lesdits dispositifs et sont soudés, sur lesdits collecteurs, des conducteurs qui relient, entre eux, électriquement lesdits dispositifs, un second poste prévu pour recevoir une file de chariots issue du premier poste sur lesquels reposent lesdits dispositifs disposés en une rangée et soudés au premier poste et pour décharger ladite rangée de dispositifs, et un troisième poste où est mise en attente une file de chariots dont ladite rangée de dispositifs vient d'être déchargée au second poste, les opérations de décharge d'une file au second poste et de sa mise en attente au troisième poste étant réalisées consécutivement pendant que, sur une autre file au premier poste, sont réalisés l'assemblage et le soudage desdits dispositifs.

2. Machine selon la revendication 1, caractérisée en ce que le premier poste est constitué d'un premier emplacement où, pour chaque chariot d'une file, un dispositif à semi-conducteur est d'abord positionné sur ledit chariot, puis des conducteurs sont amenés et positionnés sur ledit dispositif de manière que lesdits conducteurs puissent se trouver en contact avec les collecteurs dudit dispositif, lesdits conducteurs ayant une première extrémité reposant sur ledit dispositif et l'autre sur le chariot suivant dans la file, et enfin où des moyens de pressage pressent l'ensemble ainsi formé dudit dispositif, des conducteurs éventuels sur sa face arrière et des conducteurs sur sa face avant, et un second emplacement où des moyens de chauffage fournissent de la chaleur auxdits conducteurs pour effectuer leur soudage sur lesdits collecteurs de contact, chaque chariot d'une file étant prévu pour d'abord passer devant le premier emplacement puis devant le second emplacement,

3. Machine selon la revendication 2, caractérisée en ce que chaque chariot est muni de moyens de chauffage qui lui sont propres.

4. Machine selon la revendication 2 ou 3, caractérisée en ce que lesdits moyens de chauffage sont constitués de moyens d'émission infrarouge.

5. Machine selon la revendication 4, caractérisée en ce que les moyens d'émission infrarouge sont au moins une résistance électrique.

6. Machine selon une des revendications 2 à 5, caractérisée en ce que deux électrodes de mesure, une en cuivre et l'autre en cupronickel, sont prévues pour venir en contact, pendant l'opération de soudage, avec au moins un des conducteurs reliant chaque dispositif à semi-conducteur entre eux, ladite électrode en cupronickel jouant alors le rôle d'un thermocouple, une tension représentative de la température de la soudure étant délivrée aux bornes des deux électrodes de mesure.

7. Machine selon la revendication 6, caractérisée en ce que la tension délivrée aux bornes desdites électrodes de mesure est fournie à une unité de commande qui pilote lesdits moyens de chauffage.
